# EUROPÄISCHE PATENTSCHRIFT

(11) **EP 1 369 995 B1**
(45) Veröffentlichungstag und Bekanntmachung des Hinweises auf die Patenterteilung: **17.10.2007**
(21) Anmeldenummer: 03005900.0
(22) Anmeldetag: 17.03.2003
(51) Int. Cl.: H03J 1/00, H04H 9/00

(54) **Verfahren und System zum Ordnen oder Sortieren von Kanälen**
Method and system for arranging and sorting of channels
Méthode et système de rangement et de triage de canaux

(30) Priorität: 04.06.2002 DE 10224697
(43) Veröffentlichungstag der Anmeldung: 10.12.2003
(73) Patentinhaber: ROBERT BOSCH GMBH, 70442 Stuttgart (DE)
(72) Erfinder: Schreiner, Joerg, 60594 Frankfurt (DE)

(56) Entgegenhaltungen:
- WO-A-02/087243
- US-B1- 6 182 287
- PATENT ABSTRACTS OF JAPAN Bd. 1999, Nr. 13, 30. November 1999 (1999-11-30) & JP 11 220675 A (TOSHIBA CORP), 10. August 1999 (1999-08-10)

## Beschreibung

### Technisches Gebiet

Die vorliegende Erfindung betrifft ein Verfahren sowie ein System zum Ordnen oder Sortieren von ausgestrahlte Informationen und/oder Inhalte transportierenden empfangbaren Kanälen, insbesondere Rundfunkkanälen, gemäß mindestens einem Ordnungs- oder Sortierprinzip.

### Stand der Technik

Empfangsgeräte, insbesondere Fernsehgeräte oder Radiogeräte, ermöglichen heutzutage das Speichern von empfangenen Kanälen auf sogenannten Programmplätzen. In Abhängigkeit vom Empfangsgerät stehen hierfür einige wenige Speicherplätze bis zu Hunderte von verschiedenen Speicherplätzen zur Verfügung. Das Zuordnen oder Zuweisen der Empfangskanäle auf die üblicherweise durchnumerierten Programmplätze erfolgt entweder manuell durch den Benutzer des Empfangsgeräts oder automatisch durch eine Spezialfunktion des Empfangsgeräts, im folgenden automatische Kanalspeicherung genannt.

Das manuelle Sortieren durch den Benutzer des Empfangsgeräts ist für den Benutzer mühsam und zeitaufwendig, bringt für den Benutzer jedoch in der Regel den Vorteil mit sich, daß die Empfangskanäle in einer für den Benutzer bekannten und komfortabel erreichbaren Reihenfolge angeordnet sind. Die vom Benutzer am meisten genutzten Empfangskanäle werden typischerweise auf den am leichtesten erreichbaren Programmplätzen gespeichert. Voraussetzung für diese Programmierung sind eine Liste der Empfangskanäle sowie genaue Kenntnisse des Benutzers über die Programmierung der Programmplätze.

Hingegen liegt der Vorteil der automatischen Kanalspeicherung zum einen in einer Zeitersparnis bei der Programmierung, zum anderen darin, daß das Empfangsgerät auch neue, dem Benutzer zuvor unbekannte Empfangskanäle finden und automatisch auf den Programmplätzen speichern kann. Die gespeicherten Empfangskanäle werden bei Rundfunkempfangsgeräten typischerweise nach Empfangseigenschaften gefiltert, um die begrenzte Anzahl der zur Speicherung vorhandenen Programmplätze nicht unnötigerweise durch schlecht empfangbare Sender zu blockieren. Die Empfangskanäle sind nach der automatischen Kanalspeicherung stets in nicht vorhersehbarer Weise auf die Programmplätze verteilt.

Damit nun die vom Benutzer am meisten genutzten Frequenzen auf den leicht erreichbaren Programmplätzen liegen, ist der Benutzer fast immer zu einer manuellen Neuzuweisung gezwungen. In der anbrechenden Ära des digitalen Rundfunks mit Hunderten von angebotenen Kanälen wird dieses manuelle Sortieren zu einer die Geduld sowie die Zeit des Benutzers überstrapazierenden Arbeit.

Aus der US-B-6 182 287 ist ein Verfahren zum Ordnen oder Sortieren von Inhalte transportierenden Kanälen in einem Multimediagerät bekannt, bei dem bevorzugte Kanäle in einer automatisch generierbaren Favoritenliste gespeichert werden, wobei die Favoritenliste Einträge der am meisten genutzten Kanäle enthalten kann. Dies erleichtert einen Zugriff auf die durch den Nutzer bevorzugten Kanäle.

### Darstellung der Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, ein Verfahren der eingangs genannten Art sowie ein System der eingangs genannten Art so weiterzuentwickeln, daß auch bei einer Vielzahl von empfangbaren Kanälen ein einfaches, intuitives und sinnvolles Prinzip zum Ordnen bzw. Sortieren dieser Kanäle eingehalten ist.

Diese Aufgabe wird gemäß der Lehre der vorliegenden Erfindung durch ein Verfahren mit den im Anspruch 1 genannten Merkmalen sowie durch ein System mit den im Anspruch 6 genannten Merkmalen gelöst. Vorteilhafte Ausgestaltungen und zweckmäßige Weiterbildungen der vorliegenden Erfindung sind in den jeweiligen Unteransprüchen gekennzeichnet.

Mithin ist der Kern der vorliegenden Erfindung in einer Kanalsortierung nach Benutzungsdauer zu sehen; dies bedeutet mit anderen Worten, daß die Kanäle gemäß der Dauer und/oder Intensität der Inanspruchnahme oder Nutzung der durch den jeweiligen Kanal transportierten Informationen und/oder Inhalte geordnet oder sortiert und dann ersetzt werden, falls die gemessene Nutzungsdauer einen vorgegebenen Schwellwert unterschreitet.

Gemäß einer Weiterbildung des vorliegenden Verfahrens wie auch des vorliegenden Systems erfolgt in diesem Zusammenhang ein automatisches Verteilen der vom Benutzer am meisten und/oder am intensivsten benutzten Empfangskanäle auf die am leichtesten und/oder am besten erreichbaren Programmplätze.

Dies zeitigt zunächst den Vorteil, daß die auf den Programmplätzen gespeicherten Sender auf einfache Weise um neue Sender aktualisiert werden können, ohne daß die dem Benutzer vertraute Reihenfolge "seiner" wichtigsten Empfangskanäle durcheinander gerät.

Ein weiterer Vorzug der vorliegenden Erfindung ist darin zu sehen, daß der Benutzer ihm zuvor unbekannte Empfangskanäle leicht und wiederholt nutzen kann, denn diese Empfangskanäle können in einfacher Weise auf den Programmplätzen gespeichert werden, ohne daß der Benutzer die Liste der verfügbaren Empfangskanäle kennen muß.

Gemäß einer besonders vorteilhaften Weiterbildung der vorliegenden Erfindung können über längere Zeit genutzte Sender automatisch auf die leichter erreichbaren Programmplätze verschoben werden, so daß dem Benutzer ein schnelles Hin- und Herspringen zwischen seinen bevorzugten oder "Lieblings"kanälen ermöglicht wird. In diesem Zusammenhang wohnt dem laufenden Aktualisieren gemäß dem vorliegenden Verfahren der weitere Vorteil inne, daß der Benutzer trotz dieses laufenden Aktualisierens des Kanalangebots nicht den Überblick über seine bevorzugten Kanäle oder "Lieblings"kanäle verliert.

Des weiteren erweist es sich sowohl in bezug auf das vorliegende Verfahren als auch in bezug auf das vorliegende System als vorteilhaft, daß das erfindungsgemäß zugrunde gelegte Prinzip der Kanalsortierung nach Benutzungsdauer unabhängig von bereits bekannten Ordnungs-/Sortierverfahren - wie im Stand der Technik beschrieben - genutzt werden kann, ohne deren Funktionsweise zu verändern.

Dementsprechend betrifft die vorliegende Erfindung schließlich ein Empfangsgerät, insbesondere Rundfunkempfangsgerät, arbeitend gemäß einem Verfahren gemäß der vorstehend dargelegten Art und/oder aufweisend mindestens ein System gemäß der vorstehend dargelegten Art.

Eine Sortiereinrichtung nach Benutzungsdauer kann also erfindungsgemäß in allen Empfangsgeräten, bei denen ein empfangener Kanal einem von mehreren Programmplätzen zugeordnet werden kann, eingesetzt werden; dies sind insbesondere Rundfunk-Empfangsgeräte für Digital-Audio-, Digital-Video-, Fernseh-, Radio- und/oder Videotext-Programme sowie andere Empfangsgeräte für digitale Medien, wie etwa für das Internet oder für W[ireless]A[pplication]P[rotocol].

Die vorliegende Erfindung funktioniert unabhängig von der konkreten Anzahl der Kanäle sowie unabhängig von der konkreten Anzahl der Programmplätze; des weiteren funktioniert die vorliegende Erfindung unabhängig von der Auswahl oder von der manuellen Programmierung eines konkreten Programmplatzes und des diesem Programmplatz zugewiesenen konkreten Empfangskanals.

### Kurze Beschreibung der Zeichnungen

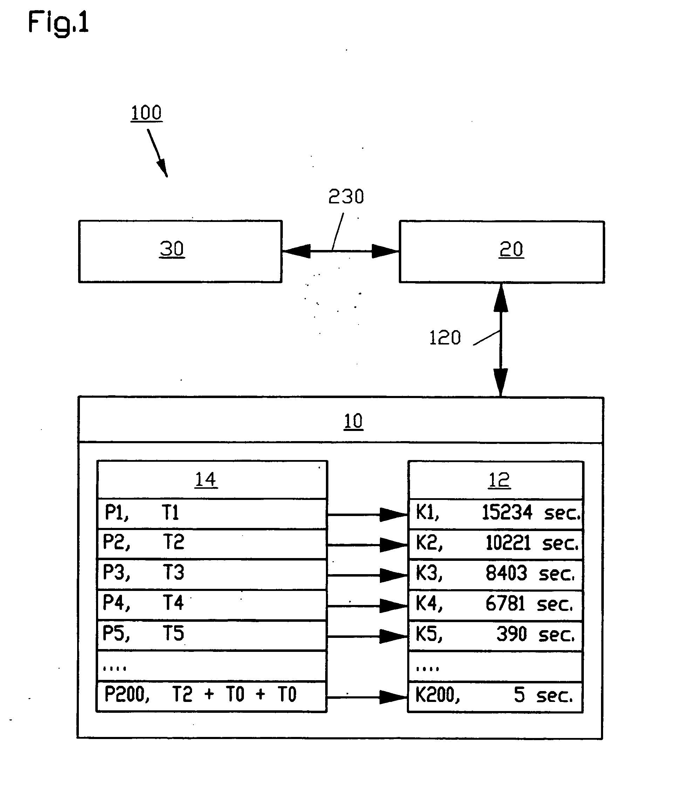

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die den Ansprüchen 1 und 7 nachgeordneten Ansprüche verwiesen, andererseits werden weitere Ausgestaltungen, Merkmale und Vorteile der vorliegenden Erfindung nachstehend anhand des durch Figur 1 veranschaulichten Ausführungsbeispiels näher erläutert.

Es zeigt:
- Fig. 1: eine schematische Prinzipdarstellung eines Ausführungsbeispiels für ein System auf das die vorliegende Erfindung angewendet werden kann, das dann gemäß dem Verfahren gemäß der vorliegenden Erfindung funktioniert.

### Bester Weg zur Ausführung der Erfindung

In Figur 1 wird das Funktionsprinzip eines Systems 100 zum Ordnen bzw. Sortieren von zweihundert ausgestrahlte Informationen oder Inhalte transportierenden empfangbaren Rundfunkkanälen K1, K2, K3, K4, K5, ..., K200 gemäß einem Ordnungs- oder Sortierprinzip skizziert. Die Endgerätekombination des Systems 100 kann hierbei wie folgt gestaltet sein:

Ein Rundfunk-Empfangsgerät (Fernseher) mißt in einer Rechner-Zentraleinheit 20 mit Speichereinheit 10 die Zeit, während der jede am Rundfunk-Empfangsgerät ausgewählte Senderfrequenz vom Benutzer genutzt wird, und speichert diese in einer Liste 12 (= sogenannte Kanalliste) der genutzten Senderfrequenzen ab; diese Kanalliste 12 kann rechnergestützt automatisch nach Benutzungsdauer sortiert werden:

So wurden im gezeigten Ausführungsbeispiel gemäß Figur 1 vom Benutzer des Rundfunk-Empfangsgeräts bislang die jeweiligen Informationen und jeweiligen Inhalte
- des ersten Kanals K1 genau 15.234 Sekunden,
- des zweiten Kanals K2 genau 10.221 Sekunden,
- des dritten Kanals K3 genau 8.403 Sekunden,
- des vierten Kanals K4 genau 6.781 Sekunden,
- des fünften Kanals K5 genau 390 Sekunden,
- ... und des zweihundertsten Kanals K200 genau fünf Sekunden
in Anspruch genommen, das heißt genutzt.

In einer zweiten, ebenfalls in der Speichereinheit 10 bereitgehaltenen Liste, nämlich in der sogenannten Programmplatzliste 14 sind zweihundert Programmplätze P1, P2, P3, P4, P5, ..., P200 mit den zur jeweiligen Auswahl erforderlichen Tastenkombinationen T1, T2, T3, T4, T5, ..., T2+T0+T0 abgelegt, und zwar sortiert nach Güte der Erreichbarkeit der Tastenkombinationen T1, T2, T3, T4, T5, ..., T2+T0+T0 durch den Benutzer.

Die einzelnen Sendefrequenzen (= Kanal K1, K2, K3, K4, K5, ..., K200) aus Kanalliste 12 werden nun erfindungsgemäß jeweils einem Programmplatz P1, P2, P3, P4, P5, ..., P200 aus Programmplatzliste 14 zugeordnet bzw. zugewiesen. Hierbei werden erfindungsgemäß die zeitlich am häufigsten bzw. am meisten in Anspruch genommenen und genutzten Kanäle K1, K2, K3, K4, K5 den am besten und am leichtesten erreichbaren Programmplätzen P1, P2, P3, P4, P5 zugeordnet bzw. zugewiesen; diese Programmplätze P1, P2, P3, P4, P5 sind auf einfache und schnelle Weise mittels der auf einer Fernbedienung vorgesehenen Tasten T1, T2, T3, T4, T5 anwählbar und erreichbar.

Dieses Zuordnen bzw. Zuweisen kann sich mit jedem neuen Sortieren der Kanalliste 12 und einer damit einhergehenden Änderung der Numerierung bzw. Reihenfolge der Kanäle K1, K2, K3, K4, K5, ..., K200 ändern.

Die Ordnung bzw. Sortierung kann rechnergestützt automatisch (--> Rechner-Zentraleinheit 20, die über eine Verbindungsleitung 230 mit einer Rundfunk-Empfangseinheit 30 zum Empfangen der Senderfrequenzen in Verbindung steht) oder manuell durchgeführt werden. Ein automatisch festgelegter oder vom Benutzer einstellbarer Schwellwert entscheidet darüber, unterhalb welcher (in Sekunden) gemessenen Benutzungsdauer wenig benutzte Senderfrequenzen automatisch durch angebotene, aber derzeit nicht in der Speichereinheit 10 gespeicherte Senderfrequenzen ersetzt werden können.

Abschließend sei noch angemerkt, daß der Begriff "Rundfunk" im Zusammenhang mit der vorliegenden Erfindung nicht auf den darunter oftmals verstandenen, über eine amplitudenmodülierte (= AM) oder frequenzmodulierte (= FM) Rundfunkfrequenz übertragenen Hörrundfunk, oftmals im deutschsprachigen Raum auch umgangssprachlich als "Radio" bezeichnet, beschränkt ist; vielmehr wird hier unter "Rundfunk" eine Übertragung von Informationen eines Informationsanbieters an eine Vielzahl von Empfängern verstanden.

Als Beispiel seien neben dem bekannten AM- oder FM-Hörrundfunk beispielsweise der unter dem Kürzel DAB (= Digital Audio Broadcasting) bekannte terrestrische digitale Hörrundfunk, der unter dem Kürzel DSR (= Digitales Satelliten-Radio) bekannte digitale satellitengestützte Hörrundfunk sowie das Satellitenfernsehen, das Kabelfernsehen und das terrestrische Fernsehen genannt.

Des weiteren ist Rundfunk im Zusammenhang mit der vorliegenden Erfindung nicht auf eine drahtlose Funkübertragung mittels elektromagnetischer Wellen beschränkt, sondern erstreckt sich darüber hinaus sowohl auf drahtlose Übertragung als auch auf kabelgebundene Übertragung, wie beispielsweise über Glasfäserleitungen oder Kupferleitungen.

## Patentansprüche

1. Verfahren zum Ordnen oder Sortieren von ausgestrahlte Informationen und/oder Inhalte transportierenden empfangbaren Kanälen (K), insbesondere Rundfunkkanälen, gemäß mindestens einem Ordnungs- oder Sortierprinzip,
wobei die Kanäle (K) gemäß der Dauer und/oder Intensität der Inanspruchnahme oder Nutzung der durch den jeweiligen Kanal (K) transportierten Informationen und/oder Inhalte in einer Kanalliste (12) geordnet oder sortiert werden **dadurch gekennzeichnet, dass** die Kanäle (K) in der Kanalliste (12), deren gemessene Dauer und/oder Intensität der Inanspruchnahme oder Nutzung einen automatisch festgelegten oder vom Benutzer einstellbaren Schwellwert unterschreitet, durch andere Kanäle (K) insbesondere automatisch ersetzt werden.

2. Verfahren gemäß Anspruch 1, **dadurch gekennzeichnet, daß** die geordneten oder sortierten Kanäle (K) Programmplätzen (P) zugeordnet oder zugewiesen werden, deren Numerierung und/oder Reihenfolge dem Ordnungs- oder Sortierprinzip entspricht.

3. Verfahren gemäß Anspruch 2, **dadurch gekennzeichnet, daß** die am häufigsten oder am meisten in Anspruch genommenen oder genutzten Kanäle (K) den am besten und/oder am leichtesten erreichbaren Programmplätzen (P) zugeordnet oder zugewiesen werden.

4. Verfahren gemäß mindestens einem der Ansprüche 1 bis 3, **dadurch gekennzeichnet,**
**daß** die Kanäle (K) in mindestens einer Kanalliste (12) geordnet oder sortiert werden,
**daß** die Einträge der Kanalliste (12) den Einträgen mindestens einer Programmplatzliste (14) zugeordnet oder zugewiesen werden und
**daß** die Numerierung und/oder Reihenfolge der Einträge in der Programmplatzliste (14) durch das Ordnungs- oder Sortierprinzip für die Einträge in der Kanalliste (12) definiert wird.

5. Verfahren gemäß mindestens einem der Ansprüche 2 bis 4, **dadurch gekennzeichnet, daß** den einzelnen Programmplätzen (P) jeweils mindestens eine Taste (T) insbesondere mindestens einer Bedieneinheit zugeordnet oder zugewiesen wird.

6. System (100) zum Ordnen oder Sortieren von ausgestrahlte Informationen und/oder Inhalte transportierenden empfangbaren Kanälen (K), insbesondere Rundfunkkanälen, gemäß mindestens einem Ordnungs- oder Sortierprinzip in einer Kanalliste (12),
wobei das Ordnungs- oder Sortierprinzip durch die Dauer und/oder Intensität der Inanspruchnahme oder Nutzung der durch den jeweiligen Kanal (K) transportierten Informationen und/oder Inhalte gegeben ist, **dadurch gekennzeichnet,dass** eine insbesondere automatische Ersetzung solcher Kanäle (K) in der Kanalliste (12) durch andere Kanäle (K) vorgesehen ist, deren gemessene Dauer und/oder Intensität der Inanspruchnahme oder Nutzung einen automatisch festgelegten oder vom Benutzer einstellbaren Schwellwert unterschreitet.

7. System gemäß Anspruch 6, **dadurch gekennzeichnet,**
**daß** für die Kanäle (K) mindestens eine Kanalliste (12) vorgesehen ist,
**daß** die Kanäle (K) in der Kanalliste (12) Programmplätzen (P) in mindestens einer Programmplatzliste (14) zuordbar oder zuweisbar sind und
**daß** die Numerierung und/oder Reihenfolge der Programmplätze (P) in der Programmplatzliste (14) durch das Ordnungs- oder Sortierprinzip für die Kanäle (K) in der Kanalliste (12) definiert ist.

8. System gemäß Anspruch 6 oder 7, **gekennzeichnet durch**
mindestens eine Speichereinheit (10) zum Speichern der Kanäle (K) und der Programmplätze (P),
mindestens eine mit der Speichereinheit (10) in Verbindung (120) stehende Zentraleinheit (20), insbesondere Rechner-Zentraleinheit, sowie
mindestens eine mit der Zentraleinheit (20) in Verbindung (230) stehende Empfangseinheit (30), insbesondere Rundfunk-Empfangseinheit.

9. Empfangsgerät, insbesondere Rundfunkempfangsgerät, arbeitend gemäß einem Verfahren gemäß mindestens einem der Ansprüche 1 bis 5 und/oder aufweisend mindestens ein System (100) gemäß mindestens einem der Ansprüche 6 bis 8.

## Claims

1. Method for arranging or sorting receivable channels (K), transporting radiated information and/or contents, particularly broadcast channels, in accordance with at least one principle of arranging or sorting,
wherein the channels (K) are arranged or sorted in a channel list (12) in accordance with the duration and/or intensity of the utilization or use of the information and/or contents transported by the respective channel (K), **characterized in that** the channels (K) in the channel list (12), the measured duration and/or intensity of the utilization or use of which is below a threshold value which is automatically established or can be set by the user, are automatically replaced, in particular, by other channels (K).

2. Method according to Claim 1, **characterized in that** the arranged or sorted channels (K) are allocated or assigned to programme spaces (P), the numbering and/or sequence of which corresponds to the principle of arranging or sorting.

3. Method according to Claim 2, **characterized in that** the channels (K) utilized or used most frequently or most are allocated or assigned to the programme spaces (P) which can be reached best and/or most easily.

4. Method according to at least one of Claims 1 to 3, **characterized**
**in that** the channels (K) are arranged or sorted in at least one channel list (12),
**in that** the entries in the channel list (12) are allocated or assigned to the entries of at least one list of programme spaces (14) and
**in that** the numbering and/or sequence of the entries in the list of programme spaces (14) is defined by the principle of arranging or sorting for the entries in the channel list (12).

5. Method according to at least one of Claims 2 to 4, **characterized in that** in each case at least one key (T), particularly of at least one operating unit, is allocated or assigned to the individual programme spaces (P).

6. System (100) for arranging or sorting receivable channels (K) transporting radiated information and/or contents, particularly broadcast channels, in accordance with at least one principle of arranging or sorting in a channel list (12),
wherein the principle of arranging or sorting is given by the duration and/or intensity of the utilization or use of the information and/or contents transported by the respective channel (K), **characterized in that** an, in particular, automatic replacement of such channels (K) in the channel list (12) by other channels (K) is provided, the measured duration and/or intensity of utilization or use of which is below a threshold value which is automatically established or can be set by the user.

7. System according to Claim 6, **characterized**
**in that** at least one channel list (12) is provided for the channels (K),
**in that** the channels (K) in the channel list (12) can be allocated or assigned to programme spaces (P) in at least one list of programme spaces (14), and
**in that** the numbering and/or sequence of the programme spaces (P) in the list of programme spaces (14) is defined by the principle of arranging or sorting for the channels (K) in the channel list (12).

8. System according to Claim 6 or 7, **characterized by** at least one memory unit (10) for storing the channels (K) and the programme spaces (P),
at least one central processing unit (20), particularly a computer central processing unit, which is connected (120) to the memory unit (10), and
at least one receiving unit (30), particularly a broadcast receiving unit, which is connected (230) to the central processing unit (20).

9. Receiving device, particularly a broadcast receiving device, operating in accordance with a method according to at least one of Claims 1 to 5 and/or having at least one system (100) according to at least one of Claims 6 to 8.

## Revendications

1. Procédé de rangement et de classement de canaux (K), transportant des informations émis et/ ou des contenus et susceptibles d'êtres reçus, notamment de canaux radio mis au moins un principe de rangement ou de classement selon lequel
on range et classe les canaux (K) selon la durée et/ou l'intensité de la mise en oeuvre ou de l'utilisation des informations et/ou des contenus transportés par le canal (K) respectif, dans une liste de canaux (12),
**caractérisé en ce qu'**
on remplace notamment automatiquement par d'autres canaux (K) les canaux (K) de la liste de canaux (12) dont la durée mesurée et/ou l'intensité de la mise en oeuvre de l'utilisation sont inférieures à un seuil réglable par l'utilisateur ou fixé automatiquement.

2. Procédé selon la revendication 1,
**caractérisé en ce que**
les canaux (K) rangés ou classés sont associés à des emplacements de programme (P) ou sont attribués à ceux-ci dont le numéro et/ou la succession correspondent au principe de rangement ou de classement.

3. Procédé selon la revendication 2,
**caractérisé en ce que**
les canaux (K) utilisés ou mis en oeuvre le plus fréquemment ou le plus souvent sont associés ou sont attribués aux emplacements de programme (P) les mieux et/ou les plus facilement accessibles.

4. Procédé selon au moins l'une des revendications 1 à 3,
**caractérisé en ce que**
les canaux (K) sont rangés ou classés en au moins une liste de canaux (12),
les enregistrements de la liste de canaux (12) sont associés ou attribués aux enregistrements d'au moins une liste d'emplacementd de programme (14) et
la numérotation et/ou la succession en série des enregistrements dans la liste des emplacements de programme est définie par le principe de rangement ou de classement pour les enregistrements dans la liste de canaux (12).

5. Procédé selon l'une des revendications 2 à 4,
**caractérisé en ce qu'**
on associe ou on attribue notamment une touche (T) en particulier d'au moins une unité de service aux différents emplacements de programme (P).

6. Système (100) pour ranger ou classer des canaux (K) transportant des informations et/ou des contenus émis, ces canaux pouvant être reçus, notamment des canaux radio selon au moins un principe de rangement ou de classement dans une liste de canaux (12),
selon lequel on définit le principe de rangement ou de classement par la durée et/ou l'intensité de la mise en oeuvre ou de l'utilisation des informations transportées par le canal respectif (A) et/ou les contenus,
**caractérisé par**
un remplacement notamment automatique par d'autres canaux (K) des canaux (K) de la liste (12) dont la durée mesurée et/ou l'intensité de la mise en oeuvre ou de l'utilisation passe en dessous d'un seuil fixé automatiquement ou réglable par l'utilisateur.

7. Système selon la revendication 6,
**caractérisé en ce qu'**
au moins une liste de canaux (12) est prévue pour les canaux (K),
les canaux (K) de la liste (12) sont attribués ou affectés à des emplacements de programme (P) dans au moins une liste de programmes (14) et la numérotation et/ou la succession d'ordre des emplacements de programme (P) est définie dans la liste de programmes (14) par le principe de rangement ou de classement des canaux (K) dans la liste de canaux (12).

8. Système selon la revendication 6 ou 7,
**caractérisé par**
au moins une unité de mémoire (10) pour enregistrer les canaux (K) et les emplacements de programme (P),
au moins une unité centrale (20) en liaison (120) avec l'unité de mémoire (10), notamment une unité centrale de calculateur et
au moins une unité de réception (30), notamment une unité de réception radio en liaison (230) avec l'unité centrale (20) ?

9. Récepteur notamment récepteur radio fonctionnant selon un procédé de l'une au moins des revendications 1 à 5 et/ou ayant au moins un système (100) correspondant à au moins l'une des revendications 6 à 8.
